# FASCICULE DE BREVET EUROPEEN

(11) **EP 2 677 230 B1**
(45) Date de publication et mention de la délivrance du brevet: **07.06.2017**
(21) Numéro de dépôt: 13172968.3
(22) Date de dépôt: 20.06.2013
(51) Int. Cl.: F17C 3/08, F25D 19/00, G01J 5/06, H01L 23/44

(54) **Agencement pour composant électronique à refroidir, enceinte comportant l'agencement, système à froid sous vide comportant l'enceinte, procédé d'utilisation du système à froid sous vide**
Anordnung für elektronisches Bauteil zum Abkühlen, diese Anordnung umfassende Zelle, Vakuumkühlsystem, das eine solche Zelle umfasst, und Einsatzverfahren dieses Vakuumkühlsystem
Arrangement for electronic component to be cooled, enclosure having the arrangement, vacuum cold system comprising the enclosure, method of using the vacuum cold system

(30) Priorité: 22.06.2012 FR 1201773
(43) Date de publication de la demande: 25.12.2013
(73) Titulaire: Commissariat à l'Énergie Atomique et aux Énergies Alternatives, 75015 Paris (FR)
(72) Inventeur: Lasfargues, Gilles, 38000 GRENOBLE (FR); Cigna, Jean-Charles, 38250 VILLARD DE LANS (FR); Fendler, Manuel, 38000 GRENOBLE (FR)
(74) Mandataire: Ilgart, Jean-Christophe

(56) Documents cités:
- FR-A1- 2 699 263
- US-A- 3 889 119
- US-A- 4 194 119
- US-A- 4 509 342
- US-A- 5 552 608
- US-A- 6 131 394

## Description

### Domaine technique de l'invention

L'invention concerne le domaine des composants électroniques nécessitant un fonctionnement à froid.

L'invention a pour objet plus particulièrement un agencement pour composant électronique à refroidir, ledit agencement permettant, en particulier, le support dudit composant électronique.

### État de la technique

Le document US 5,552,608 décrit un composant de détection de radiations associé à un doigt froid. Un système de refroidissement du doigt induit des vibrations qui peuvent porter préjudice au fonctionnement du composant de détection. Si ces vibrations sont trop importantes, il en résulte des erreurs de mesure au niveau des signaux générés par le composant de détection. Afin de résoudre ce problème, ce document US5,552,608 propose d'utiliser un élément de liaison flexible conducteur thermique.

Bien entendu, cet élément de liaison flexible peut absorber un maximum de vibrations, mais dans certains cas, il restera toujours des vibrations induites au niveau du composant de détection. Pour résoudre la problématique d'erreurs résiduelles dues aux vibrations non absorbées, un capteur de vibrations peut être utilisé de sorte à corriger un signal issu du composant de détection en fonction d'un signal issu dudit capteur de vibrations.

Cette solution n'est pas satisfaisante dans la mesure où la simple correction électronique du signal issu du composant de détection ne permet pas d'avoir un rendu optimisé.

Le document US6,131,394 propose quant à lui de faire vibrer de manière contrôlée tout un système de refroidissement en fonction de mesures d'un capteur de vibration. Ce système n'est pas satisfaisant car lourd à mettre en oeuvre.

En outre, il est indiqué qu'il existe plus généralement un besoin de résoudre le problème des éventuelles vibrations, pour tout type de composant électronique.

### Objet de l'invention

Le but de la présente invention est de proposer une solution permettant d'optimiser le fonctionnement d'un composant électronique à refroidir.

On tend vers ce but en ce que l'agencement, pour composant électronique à refroidir lors de son fonctionnement, comporte :
- un support destiné à recevoir le composant électronique,
- une embase configurée de sorte à être refroidie,
- un élément de liaison reliant mécaniquement et thermiquement l'embase au support de sorte à le refroidir, ledit élément de liaison étant configuré de sorte que le support soit mobile par rapport à l'embase, et
- un système d'ajustement de déplacement configuré de sorte à appliquer un mouvement audit support par rapport à l'embase.

Avantageusement, l'élément de liaison est au moins en partie déformable. Par exemple, l'élément de liaison comporte deux organes d'extrémité reliés entre eux par un élément déformable, un des organes d'extrémité étant fixé à l'embase et l'autre organe d'extrémité étant fixé au support.

De préférence, l'élément déformable se présente sous la forme d'une tresse réalisée en un matériau thermiquement conducteur.

Avantageusement, la conductivité thermique de l'élément déformable est supérieure ou égale à 300W.m⁻¹.K⁻¹.

Selon une mise en oeuvre, le système d'ajustement de déplacement comporte un organe de déplacement en contact avec le support, ledit organe de déplacement étant configuré de sorte à limiter l'apport de calories issues du système d'ajustement de déplacement audit support.

Ainsi, la conductivité thermique de l'organe de déplacement peut être au moins 100 fois inférieure à la conductivité thermique de l'élément de liaison, par exemple l'organe de déplacement comporte un matériau à base de Polyethertehercetone.

Selon une mise en oeuvre, le système d'ajustement de déplacement comporte un dispositif de motorisation, de préférence à base de moteurs piézoélectriques, configuré pour mettre en mouvement l'organe de déplacement. D'autres moyens qu'un moteur peuvent être employés pour assurer la même fonction, sans sortir du cadre de l'invention.

De préférence, l'agencement est configuré de sorte que le mouvement du support soit inscrit dans un plan. En d'autres termes, durant le mouvement du support, celui-ci est contenu dans ce même plan.

L'invention est aussi relative à une enceinte à froid sous vide comprenant un agencement tel que décrit.

Avantageusement, l'embase est fixe par rapport à une cavité interne de l'enceinte dans laquelle s'étendent l'embase, l'élément de liaison et le support.

Selon une réalisation, ledit dispositif de motorisation est disposé dans l'enceinte, ou à l'extérieur de l'enceinte.

Selon une mise en oeuvre, le dispositif de motorisation étant disposé dans la cavité interne, ce dernier est fixé sur une platine de l'enceinte, ladite platine étant fixée à une paroi délimitant la cavité interne de sorte à maintenir la température de fonctionnement du dispositif de motorisation à la température ambiante de la cavité interne.

L'invention est aussi relative à un système à froid sous vide comportant une enceinte à froid sous vide et un composant électronique, notamment un laser ou un composant électronique configuré pour mesurer au moins un paramètre de longueur d'onde, monté sur le support, ledit système comportant un dispositif de refroidissement configuré pour refroidir l'embase.

L'invention est aussi relative à un procédé d'utilisation d'un système à froid sous vide selon la revendication précédente, ledit procédé comportant une étape de fonctionnement du composant électronique réalisée au cours d'une étape de refroidissement configurée de sorte à maintenir la température du composant électronique dans une plage de température de fonctionnement.

Avantageusement, le procédé comporte une étape de détection de vibrations appliquées au support, et une étape d'ajustement du déplacement du support par le système d'ajustement de déplacement en fonction des vibrations détectées afin d'inhiber lesdites vibrations pour stabiliser le composant électronique au moins au cours de l'étape de fonctionnement.

Selon une mise en oeuvre, le composant électronique est configuré pour mesurer au moins un paramètre de longueur d'onde, et l'étape de fonctionnement comporte une étape d'acquisition d'au moins un signal issu du composant électronique et représentatif du paramètre mesuré.

Selon une variante, l'étape d'acquisition comporte successivement l'acquisition d'un premier signal, le déplacement du support par le système d'ajustement de déplacement et l'acquisition d'un second signal, et le procédé comporte la génération d'une image en trois dimensions à partir des premier et second signaux.

L'invention est aussi relative à un support d'enregistrement de données lisible par un calculateur, sur lequel est enregistré un programme informatique comprenant des moyens de codes de programme informatique de mise en oeuvre des étapes d'un procédé tel que décrit.

L'invention est aussi relative à programme informatique comprenant un moyen de codes de programme informatique adapté à la réalisation des étapes du procédé, lorsque le programme est exécuté par un calculateur.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en perspective représentant un mode de réalisation particulier d'un agencement selon l'invention,
- la figure 2 est une vue en perspective représentant un élément de liaison utilisé dans l'agencement selon la figure 1,
- la figure 3 illustre un schéma de principe de réalisation d'un élément de liaison du type de celui de la figure 2,
- la figure 4 illustre une vue en perspective éclatée d'un élément de liaison du type de celui de la figure 2,
- la figure 5 représente une vue en perspective d'un agencement auquel l'élément de liaison et l'embase ont été retirés,
- la figure 6 représente une vue partielle en perspective de la figure 5 dans le sens où le support et une partie de l'organe de déplacement ont été retirés,
- la figure 7 illustre une enceinte à froid sous vide mettant en oeuvre l'agencement des figures précédentes,
- la figure 8 illustre l'évolution de la température, en fonction du temps, de différents éléments formant l'agencement lors d'une étape de mise en froid du support.

### Description de modes préférentiels de l'invention

L'agencement décrit ci-après diffère de l'art antérieur notamment en ce qu'il comporte un système d'ajustement de déplacement apte à modifier la position d'un support destiné à recevoir un composant électronique à refroidir.

Par composant électronique à refroidir, on entend un composant qui est avantageusement constamment refroidi lors de son fonctionnement de sorte qu'il reste dans une plage de température adapté à son fonctionnement. La plage de température pour un composant infrarouge à refroidir est typiquement comprise entre 70K et 90K, soit environ entre -200°C et -180°C.

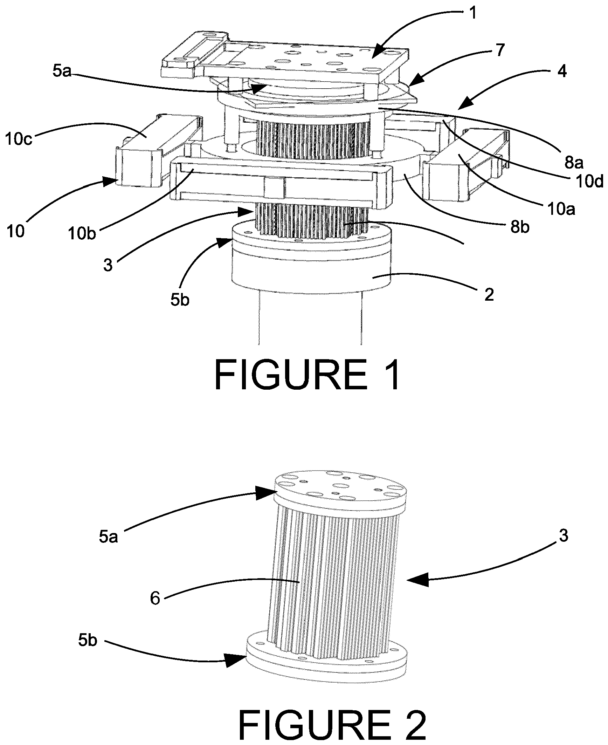

Sur la figure 1, l'agencement pour composant électronique à refroidir lors de son fonctionnement comporte un support 1 destiné à recevoir le composant électronique et une embase 2 configurée de sorte à être refroidie. Un élément de liaison 3 relie mécaniquement et thermiquement l'embase 2 au support 1 de sorte à le refroidir. En fait, le refroidissement du support 1 entraîne un refroidissement du composant électronique lorsque ce dernier est monté sur ledit support 1. Autrement dit, l'élément de liaison 3 permet l'apport de frigories à partir de l'embase 2 vers le support 1 qui les retransmet ensuite au composant électronique. Ledit élément de liaison 3 est configuré de sorte que le support 1 soit mobile par rapport à l'embase 2.

L'embase 2 et le support 1 sont, de préférence, formés dans un matériau métallique, comme par exemple le cuivre, afin d'assurer une bonne conductivité thermique.

L'élément de liaison 3 est, par exemple, configuré pour absorber au moins partiellement des vibrations en provenance de l'embase 2, ceci permettant d'éviter, ou de limiter, que ces vibrations soient transmises au support 1.

En outre, l'agencement comporte un système d'ajustement 4 de déplacement configuré de sorte à appliquer un mouvement audit support 1 par rapport à l'embase 2.

Selon l'exemple particulier de la figure 1, le système d'ajustement de déplacement 4 est configuré de sorte que le mouvement soit appliqué au support 1 sans préjudice au positionnement de l'embase 2. Autrement dit, le système d'ajustement de déplacement 4 n'induit pas de déplacement de l'embase 2 lorsqu'il met en mouvement le support 1.

Ce système d'ajustement de déplacement 4 peut alors assurer deux fonctions. Une première fonction est relative à la problématique des vibrations évoquée ci-dessus. Dans le cas où certaines vibrations seraient encore transmises malgré l'utilisation de l'élément de liaison 3 dans sa configuration permettant d'absorber au moins partiellement les vibrations, ou dans le cas où l'élément de liaison 3 n'est pas configuré pour absorber les vibrations, le système d'ajustement de déplacement 4 peut réaliser une fonction de stabilisation du support 1. Pour réaliser la stabilisation du support 1, le système d'ajustement de déplacement 4 peut être asservi, par exemple, à des données d'un capteur de mouvement de l'agencement disposé au niveau du support 1 ou de l'embase 2. La deuxième fonction est de permettre un déplacement volontaire du support 1, par exemple de sorte à placer, et à faire fonctionner, le composant électronique à au moins deux emplacements distincts.

Afin de réaliser le déplacement du support 1 par rapport à l'embase 2 l'élément de liaison 3 est avantageusement au moins en partie déformable. En fait, les caractéristiques de déformation de l'élément de liaison 3 sont telles que lorsqu'une force est appliquée par le système d'ajustement de déplacement 4 sur le support 1, l'élément de liaison 3 se déforme au moins en partie pour permettre le déplacement du support 1 sans induire de déplacement de l'embase 2.

La figure 2 illustre un mode de réalisation particulier de l'élément de liaison 3. Dans ce mode de réalisation, l'élément de liaison 3 comporte deux organes d'extrémité 5a, 5b reliés entre eux par un élément déformable 6, un des organes d'extrémité 5b étant fixé à l'embase 2 (figure 1) et l'autre organe d'extrémité 5a étant fixé au support 1 (figure 1).

L'élément déformable 6 peut se présenter sous la forme d'une tresse réalisée en un matériau thermiquement conducteur, ou d'un parallélogramme déformable formé dans un matériau thermiquement conducteur. La tresse sera par exemple réalisée à partir d'un matériau métallique, par exemple du cuivre. Cette tresse peut, par exemple, avoir une largeur de 2mm et une épaisseur de 0,5mm. Cette forme de tresse permet en particulier d'absorber les vibrations.

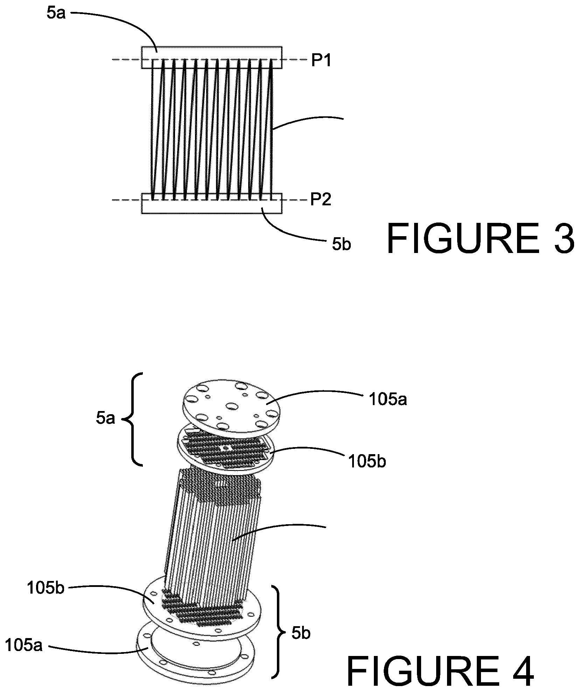

Sur l'exemple de la figure 2, l'élément déformable 6 est formé d'une unique tresse adoptant une configuration en zigzag. La configuration en zigzag correspond à une ligne brisée faisant des allers-retours entre deux plans P1, P2 sensiblement parallèles dont le schéma de principe est illustré à la figure 3. Ainsi, à chaque passage au niveau d'un des deux plans P1, P2, l'élément déformable 6 présente une extrémité configurée pour s'accoupler soit avec l'organe d'extrémité 5a au niveau du plan P1, soit avec l'organe d'extrémité 5b au niveau du plan P2. Chaque accouplement entre un organe d'extrémité 5a, 5b et l'élément déformable 6 est réalisé de sorte à favoriser l'échange thermique entre ledit organe d'extrémité 5a, 5b et l'élément déformable 6. Par exemple, pour réaliser un accouplement, l'élément déformable 6 pénètre localement à force dans une cavité correspondante de l'organe d'extrémité 5a, 5b associé. Cet accouplement par serrage, dû à l'accouplement à force, permet de favoriser le couplage thermique entre les éléments constitutifs de l'élément de liaison 3.

Par « sensiblement parallèle », on entend, de préférence, exactement parallèle, ou parallèle à plus ou moins 5 degrés.

Selon une mise en oeuvre particulière illustrée à la figure 4, les deux organes d'extrémité 5a, 5b comportent chacun une pièce pleine 105a. Une des pièces pleines est destinée à être en contact avec le support 1 et l'autre pièce pleine à être en contact avec l'embase 2. En outre, les deux organes d'extrémité 5a, 5b comportent aussi chacun une pièce perforée 105b permettant le maintien de la tresse métallique 6, et le contact de la tresse métallique, avec la pièce pleine 105a associée. L'utilisation d'une pièce pleine 105a (à l'exception d'éventuels trous de fixation) en contact physique avec l'embase 2 permet de collecter un maximum de frigories à partir de l'embase 2, et l'utilisation d'une pièce pleine 105a (à l'exception d'éventuels trous de fixations) en contact physique avec le support 1 permet de transmettre le maximum de frigories au support 1.

De manière générale, la conductivité thermique de l'élément déformable 6 (ou de l'élément de liaison) est, avantageusement, supérieure ou égale à 300W.m⁻¹.K⁻¹. Typiquement, cette valeur peut être atteinte en utilisant de l'aluminium, il est aussi possible d'utiliser du cuivre (401W.m⁻¹.K⁻¹) ou de l'or (500W.m⁻¹.K⁻¹). De préférence, on choisira une conductivité thermique comprise entre 300W.m⁻¹.K⁻¹ et 500W.m⁻¹.K⁻¹. Il en va, de préférence, de même pour les organes d'extrémité 5a, 5b qui seront respectivement en contact direct avec l'embase 2 et l'élément déformable 6, ou avec l'élément déformable 6 et le support 1.

On comprend de ce qui a été dit ci-dessus que l'on cherche à avoir une température la plus faible possible au niveau du support 1 de manière à ce que ce dernier refroidisse de manière optimisée le composant électronique de sorte à le maintenir dans une plage de température de fonctionnement adaptée. Or, dans une telle configuration, lorsque le système d'ajustement de déplacement 4 est en contact direct avec le support 1, il forme un point chaud dont il est préférable de limiter l'apport de calories au support 1. En effet, l'apport de calories au support 1 par le système d'ajustement de déplacement 4 aurait pour conséquence de dégrader le fonctionnement du composant électronique. Dans cette optique, le système d'ajustement de déplacement 4 peut comporter un organe de déplacement 7 en contact avec le support 1 (figure 1), ledit organe de déplacement 7 étant configuré de sorte à limiter l'apport de calories issues du système d'ajustement de déplacement 4 audit support 1. Pour réaliser cette fonction de limitation d'apport de calories, l'organe de déplacement peut comporter un matériau à base de Polyetherethercetone. De manière générale, la conductivité thermique de l'organe de déplacement 7 est avantageusement au moins 100 fois inférieure à la conductivité thermique de l'élément de liaison 3.

Selon une mise en oeuvre particulière, l'organe de déplacement 7 est formé par un assemblage de plusieurs pièces configurées de sorte à former des ponts thermiques afin d'augmenter les pertes thermiques.

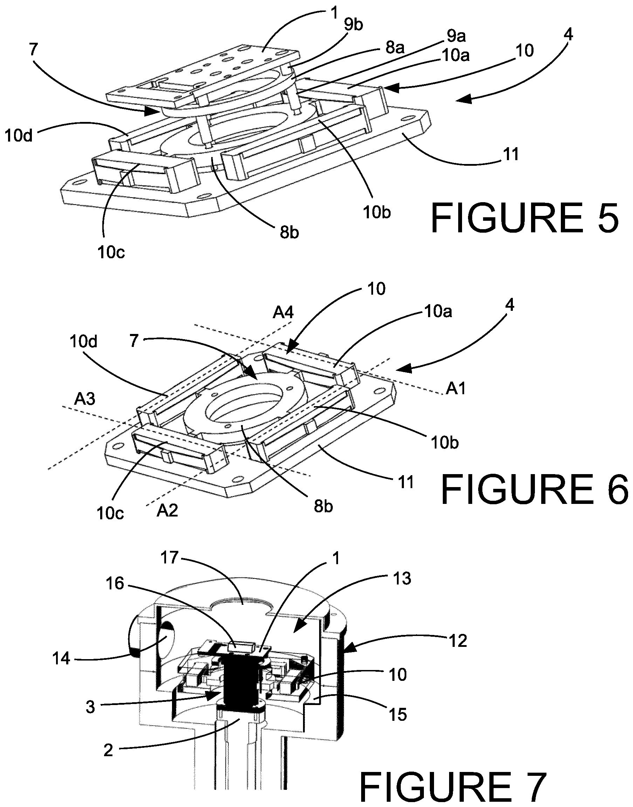

Selon l'exemple particulier de cette mise en oeuvre particulière illustrée à la figure 5, l'organe de déplacement 7 comporte deux pièces principales 8a, 8b, présentant chacune un trou débouchant, séparées par un premier élément d'entretoisement de sorte que les trous débouchant soient sensiblement co-axiaux. Le premier élément d'entretoisement se présente dans l'exemple sous la forme de trois tiges 9a chacune fixée d'une part à une des pièces principales 8b et à l'autre pièce principale 8a. Par ailleurs, une des pièces principales 8a est proximale du support 1, et est montée au support 1 par un second élément d'entretoisement se présentant dans l'exemple sous la forme de trois tiges 9b chacune fixée d'une part à la pièce principale 8a proximale du support 1 et au support 1. La figure 5 illustre pour des raisons de clarté et de compréhension l'agencement auquel on a supprimé l'embase et l'élément de liaison. En fait, l'élément de liaison 3 est monté comme illustré à la figure 1 de sorte à traverser les deux pièces principales 8a, 8b chacune par son trou débouchant, et l'organe de déplacement 7 est situé entre le support 1 et l'embase 2.

Par « sensiblement co-axiaux », on entend exactement co-axiaux ou que les trous sont disposés de telle sorte à être traversés par l'élément de liaison 3 tout en permettant une course de débattement du support 1 par rapport à l'embase 2 sans que l'élément de liaison 3 vienne en contact avec l'organe de déplacement 7.

L'organe de déplacement 7 tel que décrit ci-dessus n'est donné qu'à titre d'exemple, l'homme du métier pourra lui donner diverses autres formes du moment que ces dernières permettent de limiter l'apport de calories.

Selon une mise en oeuvre particulière, le système d'ajustement de déplacement 4 comporte un dispositif de motorisation 10 (figures 1, 5 et 6), de préférence à base de moteurs piézoélectriques, configuré pour mettre en mouvement l'organe de déplacement 7.

En fait, ce dispositif de motorisation 10 peut former un point chaud lors de son fonctionnement. Dès lors, dans le cas où l'organe de déplacement 7 est formé par un assemblage de plusieurs pièces configurées de sorte à former des ponts thermiques afin d'augmenter les pertes thermiques, ces ponts thermiques sont disposés entre le dispositif de motorisation 10 et le support 1.

Sur les figures 1, 5 et 6, le dispositif de motorisation 10 comporte de manière non limitative quatre moteurs piézoélectriques 10a, 10b, 10c, 10d. Ces quatre moteurs piézoélectriques sont disposés de sorte à permettre d'inscrire un mouvement multidirectionnel du support 1 dans un plan. Typiquement, ils sont disposés autour de l'organe de déplacement 7, et sont, dans l'exemple particulier, configurés pour être chacun en contact avec la pièce principale 8b (figures 5 et 6). Bien que cela ne soit pas représenté à la figure 1 pour des raisons de clarté, les moteurs piézoélectriques sont avantageusement montés sur une même platine 11 comme cela est visible aux figures 5 et 6. En fait, chaque moteur piézoélectrique est configuré pour se comprimer ou s'allonger le long d'un axe associé A1, A2, A3, A4 sous l'effet d'une stimulation électrique. La stimulation électrique permet alors d'ajuster le déplacement du support 1. Avantageusement, les axes sont deux à deux parallèles, et deux des axes non parallèles sont perpendiculaires entre eux.

Le composant électronique à refroidir peut, selon les cas, fonctionner uniquement qu'à de basses températures, par exemple à -200°C. Ainsi, une enceinte à froid sous vide peut comprendre un agencement tel que décrit ci-dessus.

Par « à froid », on entend que la température de l'enceinte permet en partie de maintenir un composant électronique à refroidir dans sa plage de fonctionnement. L'homme du métier saura donc adapter la valeur de température « à froid » en fonction de l'application visée.

En fait, comme illustré à la figure 7, une enceinte à froid sous vide 12 peut comporter une cavité interne 13, de préférence mise sous vide. Par « sous vide », on entend un vide secondaire par exemple de 10⁻⁵ mbar. La mise sous vide permet d'éviter toute condensation à l'intérieur de l'enceinte 12, et favorise le maintien de l'intérieur de l'enceinte 12 à basse température. La mise sous vide peut être réalisée par une ouverture 14 associée destinée à être raccordée à un dispositif de mise sous vide.

De manière générale, dans l'enceinte 12, l'embase 2 est fixe par rapport à la cavité interne 13 de l'enceinte 12 dans laquelle s'étendent l'embase 2, l'élément de liaison 3 et le support 1.

Le dispositif de motorisation 10 peut être disposé dans l'enceinte 12, ou à l'extérieur de l'enceinte 12. Sur la figure 7, le dispositif de motorisation 10 est intégré dans l'enceinte 12, c'est-à-dire qu'il se trouve dans la cavité interne 13. En fait, on disposera le dispositif de motorisation 10 hors de l'enceinte 12 lorsque le fonctionnement celui-ci est susceptible d'être impacté par le froid, ou par le vide régnant dans l'enceinte 12. Lorsque le dispositif de motorisation 10 est disposé à l'extérieur de l'enceinte 12, il est accouplé à l'organe de déplacement par un dispositif de transmission hermétique par exemple de type tombac. Un tombac est un soufflet métallique permettant la propagation d'un mouvement au travers d'une paroi étanche.

Le dispositif de motorisation 10 est avantageusement fixé à une paroi 15, délimitant la cavité interne 13 de l'enceinte à froid sous vide 12, par la platine 11. Cette fixation permet de maintenir le dispositif de motorisation 10 à une température ambiante de l'intérieur de l'enceinte afin de ne pas dégrader les performances de ce dernier. En effet, dans le cas de l'utilisation de moteurs piézoélectriques, en dessous d'une certaine température, ces derniers peuvent perdre 80% de leur efficacité. Autrement dit, lorsque le dispositif de motorisation 10 est disposé dans la cavité interne 13, ce dernier est fixé sur une platine 11 de l'enceinte 12, ladite platine 11 étant fixée à une paroi 15 délimitant la cavité interne 13 de sorte à maintenir la température de fonctionnement du dispositif de motorisation 10 à la température ambiante de la cavité interne 13. Dans ce cas, la température du dispositif de motorisation 10 tend vers celle de la paroi 15 de la cavité interne 13 de l'enceinte 12.

L'enceinte est destinée à recevoir un composant électronique 16, notamment un laser, ou un composant électronique configuré pour mesurer au moins un paramètre de longueur d'onde (par exemple un capteur infrarouge). Ce composant électronique est monté sur le support 1. Typiquement ce composant doit pouvoir interagir avec l'extérieur de l'enceinte à froid sous vide 12 pour, par exemple, recevoir des informations (cas de la mesure de longueur d'onde), ou pour par exemple émettre des informations (cas du laser). Pour cela, l'enceinte à froid sous vide peut comporter un hublot 17, un tel hublot 17 est transparent aux informations.

L'enceinte 12 comporte une configuration dans laquelle elle est hermétique de sorte que la pression reste constante dans la cavité interne 13.

Afin d'assurer le refroidissement du composant électronique 16, l'embase 2 peut être refroidie par tout type de dispositif de refroidissement adapté. A titre d'exemple, il peut être utilisé un cryostat à bain, ou une machine à froid. Dans le cas d'un cryostat à bain, l'embase 2 est refroidie grâce à la circulation, en contact de celle-ci, d'un liquide froid (azote liquide ou hélium liquide). Dans le cas de la machine à froid, l'embase 2 est refroidie grâce à un cycle de compression et décompression d'un gaz. Le cas de la machine à froid sera préféré car il est plus simple à mettre en oeuvre. En effet, le cryostat à bain nécessite de remplir régulièrement un réservoir de liquide.

La présente enceinte 12 permet, lorsque l'embase 2 est refroidie, de placer le composant électronique 16 monté sur le support 1 dans une plage de température de fonctionnement idoine, par exemple inférieure à -200°C.

Les applications possibles de la présente enceinte 12 sont les domaines de l'électronique et de l'optique.

Un système à froid sous vide peut donc comporter une enceinte à froid sous vide 12 telle que décrite ci-dessus et un composant électronique 16 (par exemple du type de ceux décrit ci-dessus) est monté sur le support 1. Le système comporte en outre un dispositif de refroidissement, par exemple tel que ceux évoqués ci-dessus, configuré pour refroidir l'embase 2.

L'invention est aussi relative à un procédé d'utilisation du système à froid sous vide tel que décrit. Le procédé comporte une étape de fonctionnement du composant électronique 16 réalisé au cours d'une étape de refroidissement configurée de sorte à maintenir la température du composant électronique 16 dans une plage de température de fonctionnement. Cette plage de température de fonctionnement peut être adaptée par l'homme du métier en fonction des caractéristiques du composant électronique utilisé. Cette étape de refroidissement peut mettre en oeuvre le dispositif de refroidissement et plus particulièrement peut être réalisée par refroidissement de l'embase 1 par le dispositif de refroidissement de sorte à transmettre des frigories à l'embase 2, puis à l'élément de liaison 3, puis au support 1 et enfin au composant électronique 16.

Selon une première mise en oeuvre, le procédé peut comporter une étape de détection de vibrations appliquées au support 1, et une étape d'ajustement du déplacement du support 1 par le système d'ajustement de déplacement 4 en fonction des vibrations détectées (par exemple lors de l'étape de détection) afin d'inhiber lesdites vibrations pour stabiliser le composant électronique 16 au moins au cours de l'étape de fonctionnement. Ainsi, le composant électronique 16 est stabilisé lors de son fonctionnement. Cette stabilisation dite « active » permet d'asservir le déplacement volontaire du support 1 par le système d'ajustement 4. Pour cela l'asservissement peut utiliser en entrée des données issues d'un capteur de mouvement donnant un signal représentatif du mouvement dudit support 1. Le capteur de mouvement peut être disposé au niveau du support 1, et être de type accéléromètre.

Selon une deuxième mise en oeuvre, le composant électronique 16 est configuré pour mesurer au moins un paramètre de longueur d'onde, et l'étape de fonctionnement comporte une étape d'acquisition d'au moins un signal issu du composant électronique 16, ledit signal étant représentatif du paramètre mesuré.

Selon cette deuxième mise en oeuvre, l'étape d'acquisition peut comporter successivement l'acquisition d'un premier signal, le déplacement du support 1 par le système d'ajustement de déplacement 4 et l'acquisition d'un second signal. Le procédé peut ensuite comporter la génération d'une image en trois dimensions à partir des premier et second signaux.

Dans le cadre de la réalisation de la deuxième mise en oeuvre, en prenant un composant électronique 16 muni de pixels de capture de photons de 30µm, un décalage de positionnement du composant électronique 16 selon un ou deux pixels suffit pour générer une image en trois dimensions. Avec des moteurs piézoélectriques, il est possible de déplacer le support 1, et donc le composant électronique 16 dans un carré de 100µm de côté.

De manière générale, le fait de rendre mobile le support 1 indépendamment de l'embase 2 permet d'obtenir des mouvements plus rapides, ou à des fréquences plus élevées, que dans l'art antérieur où l'ensemble complet est mis en mouvement. Il en résulte une meilleure stabilisation, et dans le cas de l'acquisition d'image à différentes positions, une mise en position rapide. Typiquement, il sera possible de réaliser des mouvements de translation du support 1 dans un plan avec une fréquence supérieure à 50Hz. Il est aussi possible avec une autre mise en oeuvre des moteurs de réaliser une mise au point selon un axe sensiblement normal au plan des mouvements en translation.

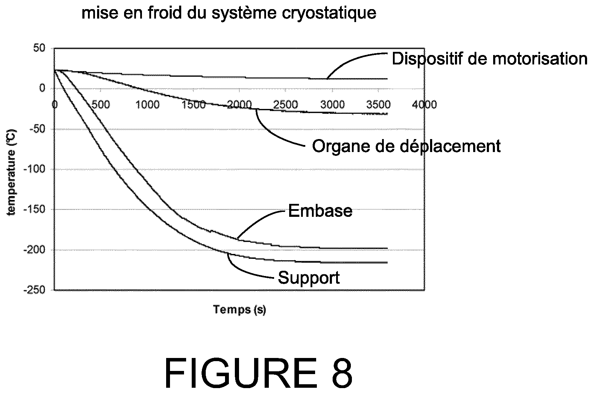

La figure 8 illustre le fonctionnement du système à froid sous vide lors de la mise du support 1 à une température de fonctionnement de -200°C du composant électronique. Sur cette figure 8, on peut voir l'évolution de la température en fonction du temps pour l'embase 2, pour le support 1, pour le dispositif de motorisation 10 à base de moteurs piézoélectriques, et pour l'organe de déplacement 7. Ce graphique permet de mettre en exergue le fait que le dispositif de motorisation 10 n'est pas impacté par la température du support 1 grâce à l'utilisation de l'organe de déplacement 7. Il est donc possible de noter le découplage thermique entre le support 1 et le dispositif de motorisation 10.

Un support d'enregistrement de données lisible par un calculateur, sur lequel est enregistré un programme informatique peut comprendre des moyens de codes de programme informatique de mise en oeuvre des étapes du procédé tel que décrit ci-dessus selon ses différentes réalisations.

Un programme informatique peut comprendre un moyen de codes de programme informatique adapté à la réalisation des étapes du procédé tel que décrit ci-dessus selon ses différentes réalisations, lorsque le programme est exécuté par un calculateur.

## Revendications

1. Agencement pour composant électronique à refroidir lors de son fonctionnement, ledit agencement comportant :
- un support (1) destiné à recevoir le composant électronique (16),
- une embase (2) configurée de sorte à être refroidie,
- un élément de liaison (3) reliant mécaniquement et thermiquement l'embase (2) au support (1) de sorte à le refroidir, ledit élément de liaison (3) étant configuré de sorte que le support (1) soit mobile par rapport à l'embase (2),
**caractérisé en ce qu'**il comporte un système d'ajustement de déplacement (4) configuré de sorte à appliquer un mouvement audit support (1) par rapport à l'embase (2).

2. Agencement selon la revendication 1, **caractérisé en ce que** l'élément de liaison (3) est au moins en partie déformable.

3. Agencement selon la revendication 2, **caractérisé en ce que** l'élément de liaison (3) comporte deux organes d'extrémité (5a, 5b) reliés entre eux par un élément déformable (6), un des organes d'extrémité (5b) étant fixé à l'embase (2) et l'autre organe d'extrémité (5a) étant fixé au support (1).

4. Agencement selon la revendication 3, **caractérisé en ce que** l'élément déformable (6) se présente sous la forme d'une tresse réalisée en un matériau thermiquement conducteur.

5. Agencement selon l'une des revendications 3 ou 4, **caractérisé en ce que** la conductivité thermique de l'élément déformable (6) est supérieure ou égale à 300W.m⁻¹.K⁻¹.

6. Agencement selon l'une quelconque des revendications précédentes, **caractérisé en ce que** le système d'ajustement de déplacement (4) comporte un organe de déplacement (7) en contact avec le support (1), ledit organe de déplacement (7) étant configuré de sorte à limiter l'apport de calories issues du système d'ajustement de déplacement (4) audit support (1).

7. Agencement selon la revendication 6, **caractérisé en ce que** la conductivité thermique de l'organe de déplacement (7) est au moins 100 fois inférieure à la conductivité thermique de l'élément de liaison (3), par exemple l'organe de déplacement (7) comporte un matériau à base de Polyethertehercetone.

8. Agencement selon l'une des revendications 6 à 7, **caractérisé en ce que** le système d'ajustement de déplacement (4) comporte un dispositif de motorisation (10), de préférence à base de moteurs piézoélectriques, configuré pour mettre en mouvement l'organe de déplacement (7).

9. Agencement selon l'une quelconque des revendications précédentes, **caractérisé en ce qu'**il est configuré de sorte que le mouvement du support (1) s'inscrive dans un plan.

10. Enceinte à froid sous vide comprenant un agencement selon l'une quelconque des revendications précédentes.

11. Enceinte selon la revendication précédente, **caractérisée en ce que** l'embase (2) est fixe par rapport à une cavité interne (13) de l'enceinte dans laquelle s'étendent l'embase (2), l'élément de liaison (3) et le support (1).

12. Enceinte selon l'une des revendications 10 ou 11 comprenant un agencement selon la revendication 8, **caractérisée en ce que** ledit dispositif de motorisation (10) est disposé dans l'enceinte (12), ou à l'extérieur de l'enceinte (12).

13. Enceinte selon la revendication 11 et la revendication 12, **caractérisée en ce que** le dispositif de motorisation (10) étant disposé dans la cavité interne (13), ce dernier est fixé sur une platine (11) de l'enceinte (12), ladite platine (11) étant fixée à une paroi (15) délimitant la cavité interne (13) de sorte à maintenir la température de fonctionnement du dispositif de motorisation (10) à la température ambiante de la cavité interne (13).

14. Système à froid sous vide comportant une enceinte (12) selon l'une des revendications 10 à 13 et un composant électronique (16), notamment un laser ou un composant électronique configuré pour mesurer au moins un paramètre de longueur d'onde, monté sur le support (1), ledit système comportant un dispositif de refroidissement configuré pour refroidir l'embase (2)

15. Procédé d'utilisation d'un système à froid sous vide selon la revendication précédente, ledit procédé comportant une étape de fonctionnement du composant électronique (16) réalisée au cours d'une étape de refroidissement configurée de sorte à maintenir la température du composant électronique (16) dans une plage de température de fonctionnement.

16. Procédé selon la revendication précédente, **caractérisé en ce qu'**il comporte une étape de détection de vibrations appliquées au support (1), et **en ce qu'**il comporte une étape d'ajustement du déplacement du support (1) par le système d'ajustement de déplacement (4) en fonction des vibrations détectées afin d'inhiber lesdites vibrations pour stabiliser le composant électronique (16) au moins au cours de l'étape de fonctionnement.

## Patentansprüche

1. Anordnung für eine während ihres Betriebs zu kühlende elektronische Komponente, wobei die Anordnung umfasst:
- einen Träger (1), welcher dazu vorgesehen ist, die elektronische Komponente (16) aufzunehmen,
- einen Sockel (2), welcher dazu eingerichtet ist, gekühlt zu werden,
- ein Verbindungselement (3), welches den Sockel (2) mechanisch und thermisch mit dem Träger (1) derart verbindet, dass er gekühlt wird,
wobei das Verbindungselement (3) derart eingerichtet ist, dass der Träger (1) gegenüber dem Sockel (2) bewegbar ist,
**dadurch gekennzeichnet, dass** sie ein System zum Anpassen einer Verlagerung (4) umfasst, welches zum Hervorrufen einer Bewegung des Trägers (1) gegenüber dem Sockel (2) eingerichtet ist.

2. Anordnung nach Anspruch 1, **dadurch gekennzeichnet, dass** das Verbindungselement (3) wenigstens teilweise deformierbar ist.

3. Anordnung nach Anspruch 2, **dadurch gekennzeichnet, dass** das Verbindungselement (3) zwei Endeinrichtungen (5a, 5b) umfasst, welche untereinander durch ein deformierbares Element (6) verbunden sind, wobei eine der Endeinrichtungen (5b) an dem Sockel (2) befestigt ist und die andere Endeinrichtung (5a) an dem Träger (1) befestigt ist.

4. Anordnung nach Anspruch 3, **dadurch gekennzeichnet, dass** das deformierbare Element (6) in Form einer Litze gebildet ist, welche aus einem Wärmeleitungs-Material hergestellt ist.

5. Anordnung nach einem der Ansprüche 3 oder 4, **dadurch gekennzeichnet, dass** die Wärmeleitfähigkeit des deformierbaren Elements (6) größer oder gleich als 300Wm⁻¹K⁻¹ ist.

6. Anordnung nach einem der vorhergehenden Ansprüche, **dadurch gekennzeichnet, dass** das System zum Anpassen einer Verlagerung (4) eine Verlagerungseinrichtung (7) in Kontakt mit dem Träger (1) umfasst, wobei die Verlagerungseinrichtung (7) derart eingerichtet ist, dass sie die Zufuhr von Kalorien begrenzt, welche von dem System zum Anpassen einer Verlagerung (4) an den Träger (1) abgegeben werden.

7. Anordnung nach Anspruch 6, **dadurch gekennzeichnet, dass** die Wärmeleitfähigkeit der Verlagerungseinrichtung (7) wenigstens 100 mal kleiner ist als die Wärmeleitfähigkeit des Verbindungselements (3), wobei die Verlagerungseinrichtung (7) beispielsweise ein Material auf Basis von Polyetheretherketon umfasst.

8. Anordnung nach einem der Ansprüche 6 bis 7, **dadurch gekennzeichnet, dass** das System zum Anpassen einer Verlagerung (4) eine Antriebsvorrichtung (10) umfasst, vorzugsweise auf Basis von piezoelektrischen Antrieben, welche dazu eingerichtet ist, die Verlagerungseinrichtung (7) in Bewegung zu versetzen.

9. Anordnung nach einem der vorhergehenden Ansprüche, **dadurch gekennzeichnet, dass** sie derart eingerichtet ist, dass die Bewegung des Trägers (1) sich in einer Ebene abspielt.

10. Vakuum-Kühlraum, umfassend eine Anordnung nach einem der vorhergehenden Ansprüche.

11. Raum nach dem vorhergehenden Anspruch, **dadurch gekennzeichnet, dass** der Sockel (2) bezüglich eines inneren Hohlraums (13) des Raums, in welchem sich der Sockel (2), das Verbindungselement (3) und der Träger (1) erstrecken, befestigt ist.

12. Raum nach einem der Ansprüche 10 oder 11, umfassend eine Anordnung nach Anspruch 8, **dadurch gekennzeichnet, dass** die Antriebsvorrichtung (10) in dem Raum (12) oder außerhalb des Raums (12) angeordnet ist.

13. Raum nach Anspruch 11 und Anspruch 12, **dadurch gekennzeichnet, dass** die Antriebsvorrichtung (10) in dem inneren Hohlraum (13) angeordnet ist, wobei letzterer an einer Platine (11) des Raums (12) befestigt ist, wobei die Platine (11) an einer Wand (15) befestigt ist, welche den inneren Hohlraum (13) derart begrenzt, dass die Betriebstemperatur der Antriebsvorrichtung (10) auf der Umgebungstemperatur des inneren Hohlraums (13) gehalten wird.

14. Vakuum-Kühlsystem, umfassend einen Raum (12) nach einem der Ansprüche 10 bis 13 und eine elektronische Komponente (16), insbesondere einen Laser oder eine elektronische Komponente, welche dazu eingerichtet ist, wenigstens einen Wellenlängen-Parameter zu messen, welche an dem Träger (1) montiert ist, wobei das System eine Kühlvorrichtung umfasst, welche dazu eingerichtet ist, den Sockel (2) zu kühlen.

15. Verfahren zur Verwendung eines Vakuum-Kühlsystems nach dem vorhergehenden Anspruch, wobei das Verfahren einen Betriebsschritt der elektronischen Komponente (16) umfasst, welcher im Verlauf eines Kühlungsschritts durchgeführt wird, welcher derart eingerichtet ist, dass die Temperatur der elektronischen Komponente (16) in einem BetriebsTemperaturbereich gehalten wird.

16. Verfahren nach dem vorhergehenden Anspruch, **dadurch gekennzeichnet, dass** es einen Schritt einer Detektion von auf den Träger (1) einwirkenden Vibrationen umfasst, und dass es einen Schritt eines Anpassens der Verlagerung des Trägers (1) durch das System zum Anpassen der Verlagerung (4) abhängig von den detektierten Vibrationen umfasst, um die Vibrationen zu unterdrücken, um die elektronische Komponente (16) wenigstens während des Betriebsschritts zu stabilisieren.

## Claims

1. Layout for an electronic component to be cooled during operation, said layout comprising:
- a support (1) on which the electronic component (16) is intended to be mounted,
- a base (2) configured so that it will be cooled,
- a connecting element (3) mechanically and thermally connecting the base (2) to the support (1) so as to cool it,
said connecting element (3) being configured such that the support (1) is free to move relative to the base (2), **characterised in that** it comprises a displacement adjustment system (4) configured so as to apply a movement to said support (1) relative to the base (2).

2. Layout according to claim 1, **characterised in that** the connecting element (3) is at least partly deformable.

3. Layout according to claim 2, **characterised in that** the connecting element (3) comprises two end devices (5a, 5b) connected to each other through a deformable element (6), one of the end devices (5b) being fixed to the base (2) and the other end device (5a) being fixed to the support (1).

4. Layout according to claim 3, **characterised in that** the deformable element (6) is preferably in the form of a braid made from a heat conducting material.

5. Layout according to either claim 3 or 4, **characterised in that** the thermal conductivity of the deformable element (6) is greater than or equal to 300W.m⁻¹.K⁻¹.

6. Layout according to claim 1, **characterised in that** the displacement adjustment system (4) comprises a displacement element (7) in contact with the support (1), said displacement element (7) being configured so as to limit the input of heat derived from the displacement adjustment system (4) to said support (1).

7. Layout according to claim 6, **characterised in that** the thermal conductivity of the displacement element (7) is at least 100 times less than the thermal conductivity of the connecting element (3), for example the displacement element (7) comprises a Polyetheretherketone-based material.

8. Layout according to claim 6, **characterised in that** the displacement adjustment system (4) comprises a motor drive device (10), preferably based on piezoelectric motors, configured to apply a movement to the displacement element (7).

9. Layout according to claim 1, **characterised in that** it is configured such that the movement of the support (1) is inscribed in a plane.

10. Vacuum cooling chamber comprising a layout according to claim 1.

11. Chamber according to the previous claim, **characterised in that** the base (2) is fixed relative to an internal cavity (13) of the chamber inside which the base (2), the connecting element (3) and the support (1) extend.

12. Chamber according to claim 10, comprising a layout according to claim 8, **characterised in that** said motor drive device (10) is located inside the chamber (12), or outside the chamber (12).

13. Chamber according to claim 11 and claim 12, **characterised in that** the motor drive device (10) is located in the internal cavity (13), and is fixed to a plate (11) in the chamber (12), said plate (11) being fixed to a wall (15) delimiting the internal cavity (13) so as to keep the operating temperature of the motor drive device (10) at the ambient temperature of the internal cavity (13).

14. Vacuum cooling system comprising a chamber (12) according to claim 10 and an electronic component (16), particularly a laser or an electronic component configured to measure at least one wavelength parameter installed on the support (1), said system comprising a cooling device configured to cool the base (2)

15. Method of using a vacuum cooling system according to the previous claim, said method comprising an operating step of the electronic component (16) made during a cooling step configured so as to keep the temperature of the electronic component (16) within an operating temperature range.

16. Method according to the previous claim, **characterised in that** it comprises a step to detect vibrations applied to the support (1), and **in that** it comprises a step to adjust displacement of the support (1) using the displacement adjustment system (4) as a function of the detected vibrations in order to eliminate said vibrations to stabilise the electronic component (16) at least during the operating step.
